(19) Europäisches Patentamt — European Patent Office — Office européen des brevets

(11) **EP 4 636 803 A1**

(12) **EUROPEAN PATENT APPLICATION**
published in accordance with Art. 153(4) EPC

(43) Date of publication:
**22.10.2025 Bulletin 2025/43**

(21) Application number: **23924244.9**

(22) Date of filing: **20.12.2023**

(51) International Patent Classification (IPC):
*H01J 43/24* (2006.01)   *H01J 37/244* (2006.01)
*H01J 49/00* (2006.01)   *H01J 49/02* (2006.01)

(52) Cooperative Patent Classification (CPC):
**H01J 37/244; H01J 43/24; H01J 49/00; H01J 49/02**

(86) International application number:
**PCT/JP2023/045776**

(87) International publication number:
**WO 2024/176600 (29.08.2024 Gazette 2024/35)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.02.2023 JP 2023026149**

(71) Applicant: **Hamamatsu Photonics K.K.**
**Hamamatsu-shi, Shizuoka 435-8558 (JP)**

(72) Inventor: **HAYASHI Masahiro**
**Hamamatsu-shi, Shizuoka 435-8558 (JP)**

(74) Representative: **Grünecker Patent- und**
**Rechtsanwälte**
**PartG mbB**
**Leopoldstraße 4**
**80802 München (DE)**

(54) **MCP DETECTOR AND ANALYSIS DEVICE**

(57) An MCP detector 1 includes: an MCP 3 including an input surface 3a to which an electron e1 is input, multipliers 11A and 11B, each being configured to multiply an electron generated in response to an input of the electron e1, and an output surface 3b from which electrons e2 resulting from multiplication by the multipliers 11A and 11B are output; a dynode 5 disposed so as to be separated from the output surface 3b and substantially parallel to the output surface 3b, and configured to multiply the electrons e2 output from the output surface 3b, the dynode 5 being in a planar shape; an anode 8 disposed between the output surface 3b and the dynode 5 so as to be separated from the output surface 3b and the dynode 5, and configured to collect electrons e3 resulting from multiplication by the dynode 5; and a dynode 7 disposed between the anode 8 and the dynode 5 so as to be separated from the anode 8 and the dynode 5, and configured to further multiply and allow the electrons e3 resulting from multiplication by the dynode 5 to pass through the dynode 7 toward the anode 8.

*Fig.1*

EP 4 636 803 A1

## Description

## Technical Field

One aspect of an embodiment relates to an MCP detector and an analysis device.

## Background Art

It is demanded for an analysis device such as a mass spectrometry (MS) including a microchannel plate (MCP) to improve output linearity of the microchannel plate. Although it has been studied to reduce the resistance of the microchannel plate in order to improve the output linearity of the microchannel plate, the improvement of the output linearity by reducing the resistance has already approached the limit.

Conventionally, a triode structure in which an anode and a dynode are combined with a microchannel plate has been studied. As a conventional charged particle detector including a triode structure, for example, an electron multiplier device described in Patent Literature 1 below is known. This electron multiplier device includes an MCP, and a dynode and a grid-like anode disposed parallel to an output surface of the MCP.

## Citation List

## Patent Literature

Patent Literature 1: Japanese Unexamined Patent Publication No. S57-196466

## Summary of Invention

## Technical Problem

In the above-described conventional electron multiplier device, the detection performance of the detector in which the MCP is mounted has peaked due to the limit of the output linearity specific to the MCP. Therefore, there is a demand to improve the detection performance of the detector in which the MCP is mounted.

Therefore, one aspect of the embodiments has been made in view of such a problem, and an objective thereof is to provide an analysis device and an MCP detector capable of improving detection performance of the detector in which an MCP is mounted.

## Solution to Problem

An MCP detector according to a first aspect of an embodiment includes: a microchannel plate including an input surface to which a charged particle is input, a multiplier configured to multiply an electron generated in response to an input of the charged particle, and an output surface from which electrons resulting from multiplication by the multiplier are output; a first dynode disposed so as to be separated from the output surface and substantially parallel to the output surface, and configured to multiply the electrons output from the output surface, the first dynode being in a planar shape; an anode disposed between the output surface and the first dynode so as to be separated from the output surface and the first dynode, and configured to collect electrons resulting from multiplication by the first dynode; and a second dynode disposed between the anode and the first dynode so as to be separated from the anode and the first dynode, and configured to further multiply and allow the electrons resulting from multiplication by the first dynode to pass through the second dynode toward the anode.

Alternatively, an analysis device according to a second aspect of the embodiment includes the above-described MCP detector.

According to the first aspect or the second aspect, among the electrons output from the output surface of the microchannel plate (hereinafter, it is also referred to as "MCP") in response to the charged particles input to the input surface of the MCP, the electrons having passed through the anode and the second dynode are multiplied by the first dynode, and electrons resulting from multiplication are further multiplied by the second dynode and pass through the second dynode toward the anode. The electrons resulting from multiplication by the second dynode are then captured by the anode. As a result, the number of electrons obtained through repeated multiplication of the output electrons of the MCP by two dynodes can be reflected to the output signal on the basis of the electrons acquired by the anode. As a result, the output linearity of the entire MCP detector can be improved, and the detection performance of the MCP detector or the analysis device including the MCP detector can be improved.

## Advantageous Effects of Invention

According to any aspect of the present disclosure, it is possible to improve the detection performance of the detector in which the MCP is mounted.

## Brief Description of Drawings

FIG. 1 is a cross-sectional view illustrating a configuration of an MCP detector 1 according to an embodiment.
FIG. 2 is a plan view illustrating a specific configuration of an anode 8.
FIG. 3 is a cross-sectional view illustrating support structures of the anode 8 and a dynode 7.
FIG. 4 is a cross-sectional view illustrating a multiplication state of secondary electrons in one channel of multipliers 11A and 11B of an MCP 3 in which potentials are set by a control unit 9.

FIG. 5 is a block diagram illustrating a configuration of a signal processing unit 9a of the control unit 9.

FIG. 6 is a graph illustrating the measurement result of the gain in each electrode when the potential of the dynode 7 is changed in the MCP detector 1.

FIG. 7 is a graph illustrating the measurement result of the gain in the MCP detector 1.

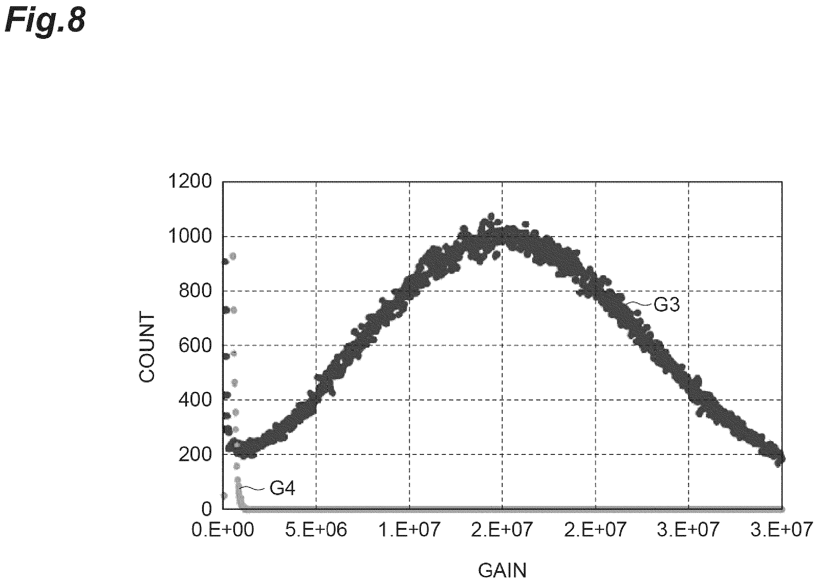

FIG. 8 is a graph illustrating the measurement result of the gain in the MCP detector 1.

FIG. 9 is a plan view illustrating a configuration of a modification of the anode 8.

FIG. 10 is a diagram for explaining a method of calculating an input position by the signal processing unit 9a on the basis of pulse signals output from the anode 8.

FIG. 11 is a diagram illustrating a display example of an image generated by the signal processing unit 9a.

FIG. 12 is a diagram illustrating a display example of an image generated by the signal processing unit 9a.

**Description of Embodiments**

Hereinafter, the embodiments of the present invention will be described in detail with reference to the accompanying drawings. Note that, in the description, the same reference numerals will be used for the same elements or elements having the same functions, and redundant description will be omitted.

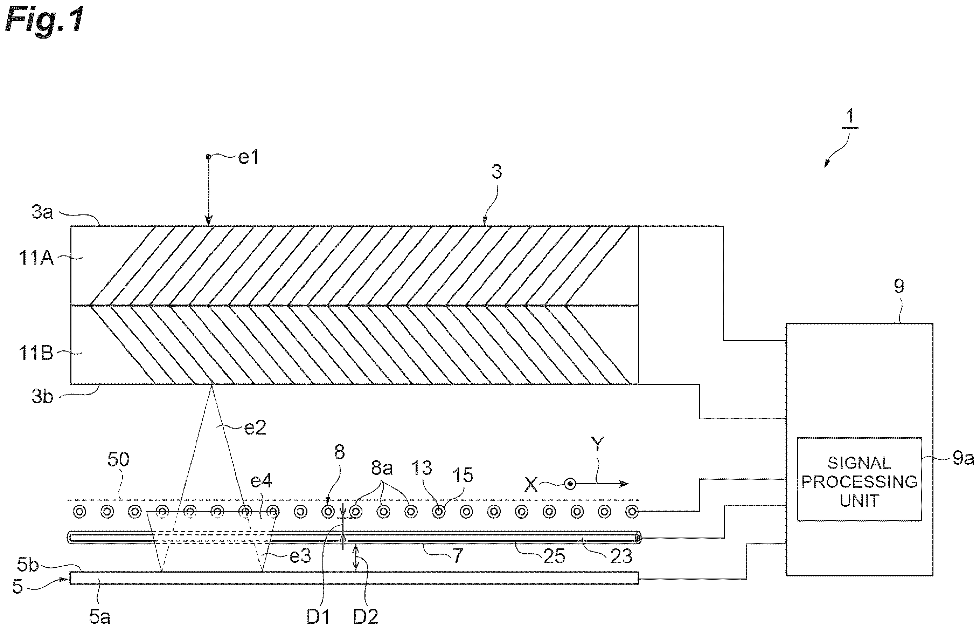

FIG. 1 is a cross-sectional view illustrating a configuration of an MCP detector 1 according to an embodiment. In FIG. 1, the circuit section is illustrated by a block. The MCP detector 1 is a device that detects charged particles that are input. The charged particles to be detected may include electrons, ions, or the like. In the present embodiment, electrons are exemplified as objects to be detected by the MCP detector 1.

As illustrated in FIG. 1, the MCP detector 1 includes an MCP 3, a dynode (first dynode) 5, a dynode (second dynode) 7, an anode 8, and a control unit 9. The MCP 3, the dynode 5, the dynode 7, and the anode 8 are formed in a substantially planar shape as a whole, and are disposed to be substantially parallel to one another. Hereinafter, a configuration of each component of the MCP detector 1 will be described.

The MCP 3 includes an input surface 3a to which electrons are input, a pair of multipliers 11A and 11B that perform multiplication of secondary electrons (secondary electron multiplication) generated in response to the input of the electrons while maintaining a two-dimensional position of the electrons with respect to the input surface 3a, and an output surface 3b from which the electrons multiplied by the multipliers 11A and 11B are output. Each of the multipliers 11A and 11B is a secondary electron multiplier having a plurality of microchannel structures independent from one another. In the multipliers 11A and 11B, a plurality of microchannel structures are two-dimensionally disposed.

Each channel of the multipliers 11A and 11B has an inner diameter of about 10 $\mu$m and is inclined by about 10 degrees with respect to the normal direction (electron input direction) of the input surface 3a. The inclination direction of the channels of the multiplier 11A and the inclination direction of the channels of the multiplier 11B are reversed from each other. In the multipliers 11A and 11B, the output surface 3b side is set to a high potential with respect to the input surface 3a side. Secondary electrons generated upon the arrival of electrons to the input surface 3a are multiplied by the multipliers 11A and 11B, and the secondary electrons resulting from multiplication are output from the output surface 3b.

The dynode 5 is an electrode that multiplies the electrons output from the MCP 3. The dynode 5 is a substantially flat plate-shaped electrode disposed substantially parallel to the output surface 3b so as to be separated from the output surface 3b of the MCP 3. That is, the dynode 5 includes a support member 5a that contains a metal material such as flat-shaped stainless steel (SUS) and a secondary electron-emitting film 5b formed on a surface of the support member 5a close to the MCP 3. The secondary electron-emitting film 5b contains, for example, a secondary electron-emitting material such as Al2O3, BeO, LiF, MgF2, MgO, CsBr, NaCl, or crystalline diamond. In addition, the support member 5a may be formed by stacking a conductor layer on a flat plate-shaped member containing an insulator material, and in this case, the secondary electron-emitting film 5b is formed on the conductor layer of the support member 5a.

The anode 8 is an electrode that is disposed between the output surface 3b of the MCP 3 and the dynode 5 so as to be separated from the MCP 3 and the dynode 5, and collects (captures) electrons multiplied by the secondary electron-emitting film 5b of the dynode 5 and emitted toward the output surface 3b. The anode 8 is disposed closer to the dynode 5 than a central position between the output surface 3b and the dynode 5. The anode 8 includes wire anodes 8a each of which extends in a first direction X along a plane substantially parallel to the output surface 3b.

Each wire anode 8a is formed by applying an antioxidant coating (gold plating) 15 to a thin metal wire (metal wire) 13 made of copper, nickel, chromium, SUS, or the like. For example, each wire anode 8a has a line width within a range of 50 $\mu$m or more and 200 $\mu$m or less. The wire anodes 8a extend in the first direction X at a plurality of positions spaced at a predetermined interval (for example, an interval of 200 $\mu$m or more and 1 mm or less) in a second direction Y perpendicular to the direction X, and are electrically connected as a whole.

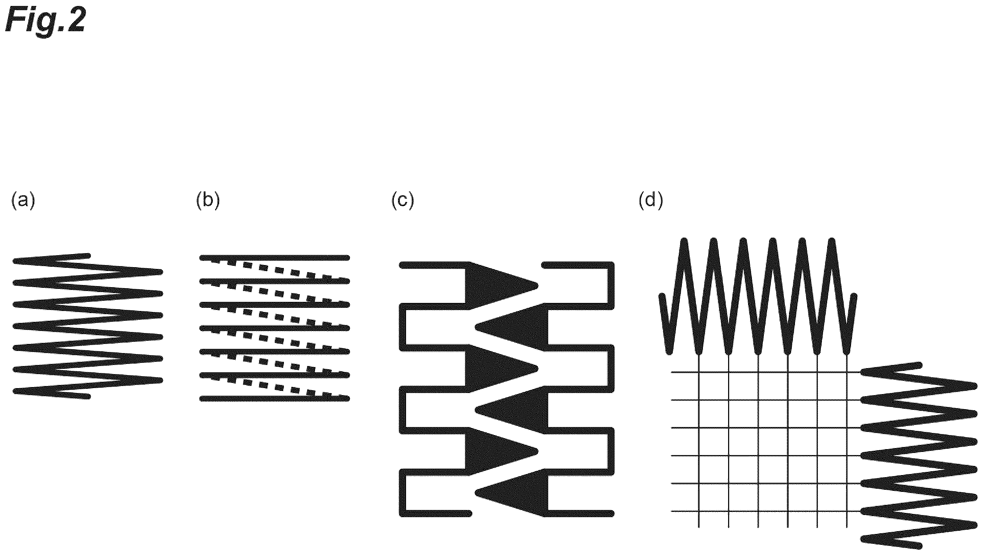

FIG. 2 is a plan view illustrating a specific configuration of the wire anodes 8a. As illustrated in part (a) of FIG. 2, each wire anode 8a may have a configuration in which a thin metal wire is disposed in a zigzag pattern bridging between a pair of facing edges of a frame-shaped support member having insulating properties (not illustrated). As illustrated in part (b) of FIG. 2, each wire anode 8a may also have a configuration in which a thin metal wire is wound around one facing edge of a frame-shaped support member having insulating properties (not illustrated) so as not to overlap one other. Note that the wire anodes 8a may have the configurations illustrated as part (a) or (b) of FIG. 2, provided as two layers, so that the two layers of thin metal wires are formed to extend in a state of being electrically insulated from each other in the first direction X and the second direction Y orthogonal to each other.

As illustrated in part (c) of FIG. 2, each wire anode 8a may also have a configuration in which two thin metal wires are disposed in parallel, each thin metal wire being folded a plurality of times at regular intervals on a flat plate-shaped support member having insulating properties (not illustrated), and two thin metal wires being electrically connected by triangular connection pads.

As illustrated in part (d) of FIG. 2, the wire anodes 8a may have a configuration in which a plurality of linear thin metal wires is formed as two layers, the thin metal wires being disposed at a predetermined interval, and electrically connected to each other in a zigzag metal pattern. Also in this case, the two layers of the thin metal wires are formed to be electrically insulated from each other with an insulating member (not illustrated) interposed therebetween and extend in the first direction X and the second direction Y orthogonal to each other.

Both ends of each of the wire anodes 8a having the above-described configurations are electrically connected to the control unit 9. In a case where the wire anodes 8a have the configurations in which two layers are formed, both ends of the thin metal wires of each layer are electrically connected to the control unit 9 independently.

The dynode 7 is an electrode that is disposed between the dynode 5 and the anode 8 so as to be separated in a direction perpendicular to the output surface 3b from the dynode 5 and the anode 8, further multiplies electrons resulting from multiplication by the dynode 5 and directed toward the anode 8, and allows the multiplied electrons to pass through the dynode 7 toward the anode 8. The dynode 7 includes a thin metal wire 23 that extends in the second direction Y along a plane substantially parallel to the output surface 3b, and a secondary electron-emitting film 25 that is formed to cover the entire thin metal wire 23. Similarly to the support member 5a of the dynode 5, the thin metal wire 23 is made of a metal material. Similarly to the secondary electron-emitting film 5b of the dynode 5, the secondary electron-emitting film 25 contains a secondary electron-emitting material. The thin metal wires 23 constituting the dynode 7 extend in the direction Y at a plurality of positions with a predetermined interval (for example, an interval of 200 μm or more and 1 mm or less) in the first direction X, and are electrically connected as a whole. The dynode 7 may adopt, for example, the configurations illustrated in part (a) and part (b) of FIG. 2.

Here, a distance D2 between the dynode 7 and the dynode 5 is set to be larger than a distance D1 between the dynode 7 and the anode 8. In addition, the anode 8 is disposed, as a whole, closer to the dynode 5 than a virtual plane 50 corresponding to an intermediate position between an intermediate position between the output surface 3b and the secondary electron-emitting film 5b of the dynode 5, and the secondary electron-emitting film 5b of the dynode 5.

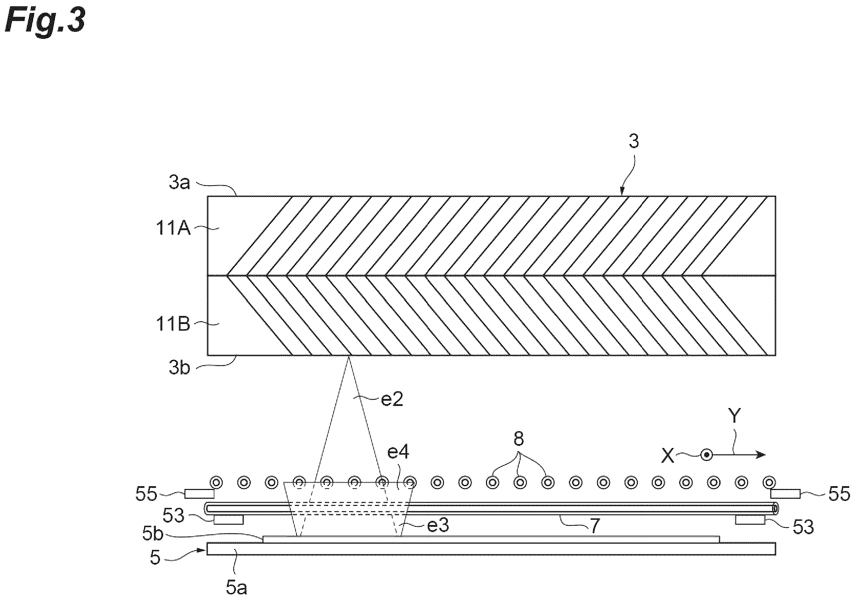

Support structures of the anode 8 and the dynode 7 will be described with reference to FIG. 3. FIG. 3 is a cross-sectional view illustrating the support structures of the anode 8 and the dynode 7. The dynode 7 includes support members 53 that support the dynode 7 and contain an insulating material, and the anode 8 includes support members 55 that support the anode 8 and contain an insulating material. The support members 53 and 55 are provided to be positioned outside a region where the secondary electron-emitting film 5b is provided on the surface of the dynode 5 closer to the MCP 3 when the dynode 5 is viewed from the output surface 3b. Note that the same members may be used as the support members 53 and the support members 55.

The control unit 9 is a circuit that is electrically connected to the input surface 3a and the output surface 3b of the MCP 3, the dynode 5, the dynode 7, and the anode 8, sets each potential, and processes the pulse signals output from the anode 8. In the control unit 9, a signal processing unit 9a is incorporated, the signal processing unit 9a processing pulse signals output from the anode 8 and performing a detection process related to electrons input to the input surface 3a of the MCP 3.

That is, the control unit 9 applies a voltage to the input surface 3a, the output surface 3b, the dynode 5, the dynode 7, and the anode 8 so that a potential of the output surface 3b is higher than a potential of the input surface 3a, potentials of the dynode 5 and the dynode 7 are higher than the potential of the output surface 3b, a potential of the anode 8 is higher than the potential of the dynode 7, and the potential of the dynode 7 is higher than the potential of the dynode 5. In other words, the control unit 9 sets each of the potentials so that the potentials of the input surface 3a, the output surface 3b, the dynode 5, the dynode 7, and the anode 8 increase in this order. For example, assuming that the potential of the input surface 3a is 0 V, the control unit 9 sets the potential of the output surface 3b to +1,920 V, the potential of the dynode 5 to +2,112 V, the potential of the anode 8 to +2,400 V, and the potential of the dynode 7 to a potential higher than +2,112 V and lower than +2,400 V.

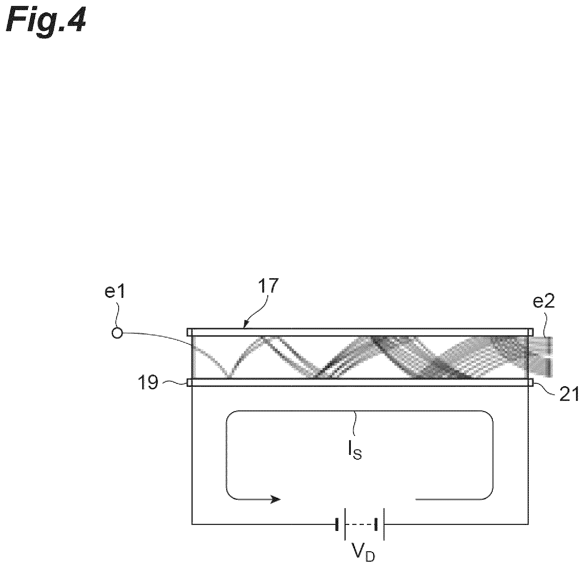

FIG. 4 is a cross-sectional view illustrating a multiplication state of secondary electrons in one channel of the multipliers 11A and 11B of the MCP 3 in which potentials are set by the control unit 9. An electrode 19 is provided at an end portion of the channel 17 on the input surface 3a side of the multipliers 11A and 11B, an electrode 21 is provided at an end portion of the channel 17 on the output surface 3b side of the multipliers 11A and 11B, and the electrode 21 of each channel 17 of the multiplier 11A and the electrode 19 of each channel 17 of the multiplier 11B are electrically connected. The control unit 9 supplies a voltage such that a potential of the electrode 19 becomes lower between the electrode 19 of the multiplier 11A and the electrode 21 of the multiplier 11B. As a result, a voltage $V_D$ is applied between both end portions of the channel 17 of each of the multipliers 11A and 11B, and a strip current $I_S$ is generated from the end portion on the output surface 3b side toward the end portion on the input surface 3a side in an inner wall portion of the channel 17. In a case where an electron e1 is input from the end portion of the channel 17 on the input surface 3a side in such a state, the electron e1 collides with the inner wall portion of the channel 17, resulting in multiplication of the electron, and secondary electrons e2 generated by repeating the multiplication of the electron in the inner wall portion of the channel 17 are output from the end portion of the channel 17 on the output surface 3b side. The output electrons of the multipliers 11A and 11B are generated by extracting a part of the strip current $I_S$, and the output linearity of the MCP3 is thus about 7% of the value of the strip current $I_S$. For this reason, it is necessary to lower a resistance value of the inner wall portion of the channel 17 in order to improve the output linearity of the MCP3 itself. Note that the output linearity means the upper limit of the number of output electrons per time during which electrons can be output while retaining a linear relationship between the number of input electrons and the number of output electrons.

The signal processing unit 9a of the control unit 9 processes pulse signals output from an end portion of the thin metal wire 13 of the anode 8 in response to electrons collected by the anode 8, and executes the detection process of detecting the number of electrons input to the input surface 3a of the MCP 3. Specifically, the signal processing unit 9a processes the pulse signals output within a predetermined time to obtain and acquires a pulse height distribution (PHD) characteristic to count the number of input electrons.

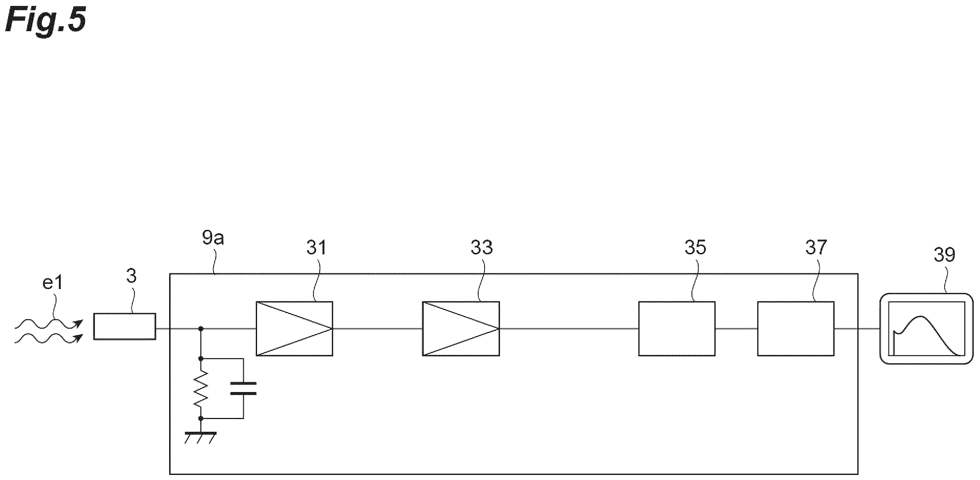

FIG. 5 is a block diagram illustrating a configuration of the signal processing unit 9a. The signal processing unit 9a includes a pre-amplifier 31, a linear amplifier 33, an A/D converter 35, and a memory 37. The pre-amplifier 31 is a charge amplifier that generates and outputs a voltage signal on the basis of a pulse signal that is a charge signal output from the anode 8 in response to the electrons e1 input to the MCP3. The linear amplifier 33 shapes a waveform of the voltage signal output from the pre-amplifier 31 into a pulse signal. The A/D converter 35 detects peak values of the voltage signal shaped by the linear amplifier, and integrates frequencies of the peak values detected within a predetermined time for each peak value. The memory 37 stores the frequency for each peak value accumulated by the A/D converter 35. The frequency distribution for each peak value stored in the memory 37 is output to an external display device 39 or the like. A peak with the PHD characteristic generated by the signal processing unit 9a means the average gain (peak channel number) of the MCP detector 1, and the average gain increases as a voltage applied to the MCP 3 increases. The signal processing unit 9a is also electrically connected to each of the dynodes 5 and 7, and can generate the PHD characteristic in each of the dynode 5 and the dynode 7. As a result, the average gain in the dynode 5 or the dynode 7 can also be interpreted as the number of output electrons.

Next, an analysis device according to an embodiment will be described. The analysis device according to the embodiment includes the above-described MCP detector 1. For example, the analysis device is a mass spectrometer (MS), a scanning electron microscopy (SEM), or the like. The analysis device may also be an X-ray photoelectron spectroscopy (XPS), a photoemission electron microscopy (PEEM), an atom probe tomography (APT), a secondary ion mass spectroscopy (SIMS), or the like.

Operation and effects of the present embodiment will be described.

In the MCP detector 1 and the analysis device including the MCP detector 1 according to the present embodiment, electrons passing through the anode 8 and the dynode 7, among the electrons e2 output from the output surface 3b in response to the electrons e1 input to the input surface 3a, are multiplied by the dynode 5, and electrons e3 resulting from multiplication are further multiplied by the dynode 7 and pass through the dynode 7 toward the anode 8. Electrons e4 resulting from multiplication by the dynode 7 are then captured by the anode 8. As a result, the number of electrons obtained through repeated multiplication of the output electrons of the MCP 3 by two dynodes 5 and 7 can be reflected to the pulse signal on the basis of the electrons acquired by the anode 8. As a result, the output linearity of the entire MCP detector can be improved, and the detection performance of the MCP detector 1 or the analysis device including the MCP detector 1 can be improved.

The detection performance of a conventional analysis device in which an MCP detector such as an XPS device is mounted has peaked due to the output linearity specific to the MCP. In recent years, in the XPS device, throughput has been improved by increasing brightness of an X-ray probe, taking measures against electrostatic charge, and the like. Therefore, in a case where the counting rate of the MCP detector can be increased, the throughput of the entire analysis device can be improved. The output linearity of the MCP detector is expressed by a product of the MCP gain and the counting rate, and the MCP gain and the counting rate are in a trade-off relationship. In addition, the output linearity specific to the MCP incorporated in the MPC detector is improved by reducing the resistance of the channels of the MCP; however, at present, there is a limit to reducing the resistance from the viewpoint of maintaining the performance of the MCP during heating. According to the present embodiment, since the output linearity of the MCP detector is improved, the counting rate can be improved while maintaining the MCP gain.

In the present embodiment, the potential of the dynode 7 is higher than the potential of the output surface 3b, and the potential of the anode 8 is higher than the potential of the dynode 7. With this setting, the electrons e2 output from the output surface 3b can efficiently reach the dynode 7, and the electrons e3 resulting from multiplication by the dynode 7 can be efficiently captured by the anode 8. As a result, the output linearity of the MCP detector 1 can be improved, and the detection performance of the MCP detector 1 or the analysis device including the MCP detector 1 can be significantly improved.

In addition, in the present embodiment, the potential of the dynode 7 is higher than the potential of the dynode 5. In this case, the electrons e3 resulting from multiplication by the dynode 5 can efficiently reach the dynode 7. As a result, the detection performance of the MCP detector 1 or the analysis device including the MCP detector 1 can be further improved.

In addition, in the present embodiment, the anode 8 includes the thin metal wire 13 extending in the first direction X along the plane, and the dynode 7 includes the thin metal wire 23 extending in the second direction Y along the plane. In this case, the output electrons e2 of the MCP 3 can be passed toward the dynode 5 with low loss, and the electrons e3 and e4 resulting from multiplication by the dynode 5 and the dynode 7 can be acquired by the anode 8 with low loss. As a result, the detection performance of the MCP detector 1 or the analysis device including the MCP detector 1 can be further significantly improved.

In addition, in the present embodiment, the distance D2 between the dynode 7 and the dynode 5 is set to be larger than the distance D1 between the anode 8 and the dynode 7. In a case where a potential difference between the anode 8 and the dynode 7 is V1 and a potential difference between the dynode 7 and the dynode 5 is V2, V1 needs to be set to several tens of volts, and V2 needs to be set to 100 to 500 V, leading to V1 < V2. This is because it is necessary to increase a potential difference Va between the output surface 3b and the dynode 5 in order to increase the total gain, and necessary to set V2 ≈ Va in order to increase the gain of the dynode 5. In this case, the distance between the dynode 7 and the dynode 5 can be ensured, and the withstand voltage can be increased even in a case where the potential difference between the dynode 7 and the dynode 5 is set high in order to increase the gain in the dynode 5.

In addition, in the present embodiment, the anode 8 is disposed closer to the dynode 5 than the virtual plane 50. In this way, the incidence efficiency (transmittance) of the electrons output from the output surface 3b of the MCP 3 to the dynode 5 is improved, and the detection performance of the MCP detector 1 can be further improved.

In addition, in the present embodiment, the dynode 7 further includes insulating support members 53 that support the dynode 7, and the support members 53 are provided on the outside, as viewed from the output surface 3b, of the region where the secondary electron-emitting film 5b is provided on a surface of the dynode 5. In a case where such a configuration is adopted, the collection efficiency of the electrons e3 resulting from multiplication and diffused by the dynode 5 can be improved in the dynode 7, and the detection performance of the MCP detector 1 can be further improved.

In addition, in the present embodiment, the anode 8 further includes the support members 55 having insulating properties and supporting the anode 8, and the support members 55 are provided outside, as viewed from the output surface 3b, the region where the secondary electron-emitting film 5b is provided on the surface of the dynode 5. In a case where such a configuration is adopted, the collection efficiency of the electrons e4 resulting from multiplication and diffused by the dynode 5, and passing through the dynode 7 can be improved in the anode 8, and the detection performance of the MCP detector 1 can be further improved.

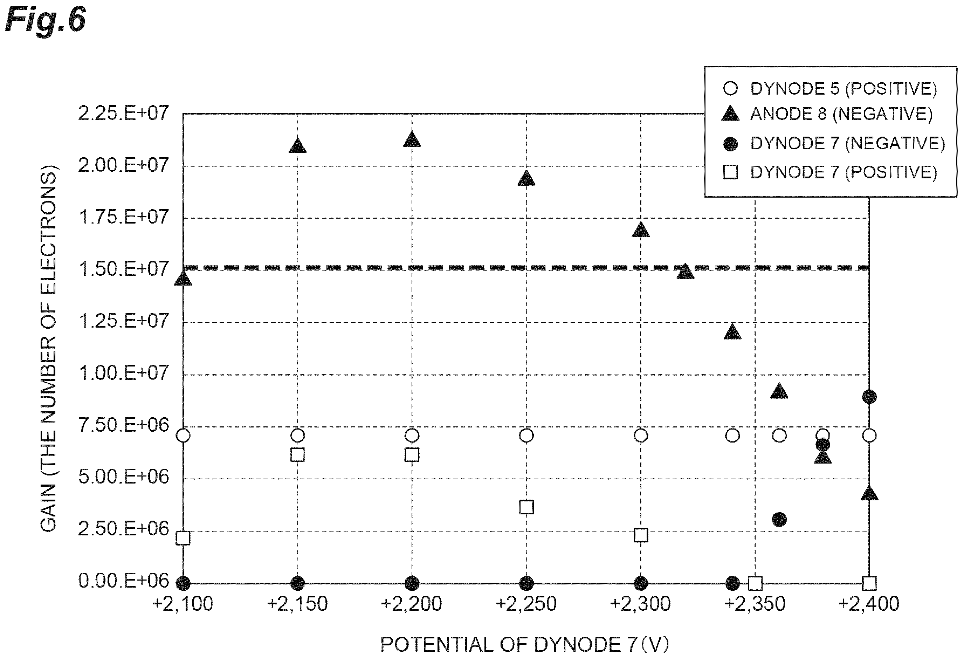

FIG. 6 is a graph illustrating the measurement result of the gain (the number of electrons included in the pulse signal) in each electrode in a case where only the potential of the dynode 7 is changed and the potentials of the other electrodes are fixed in the MCP detector 1. Here, the vertical axis represents the absolute value of the gain obtained in each electrode, and the horizontal axis represents the potential of the dynode 7. For the numerical value of each gain, a case where electrons are emitted from an electrode is defined as a positive value, and a case where electrons are absorbed by an electrode is defined as a negative value. In addition, in this measurement system, a secondary electron multiplication factor of the dynode 5 with respect to the electrons output from the MCP 3 was about 2. That is, the dynode 5 emits twice as many electrons as it absorbs, but the measurement result is 1/2 with respect to the actual gain because the difference between the absorbed electrons and the emitted electrons is measured as the gain. From this measurement result, in a case where the potential of the dynode 7 is decreased from a potential of +2,400 V equal to that of the anode 8, the gain of the anode 8 increases while the gain of the dynode 5 does not change. Here, in a case where it is assumed that the dynode 7 does not have a function of multiplying electrons, electrons output from the dynode 5 are absorbed by the dynode 7 and the anode 8. The sum of the electrons output from dynode 5 toward dynode 7 and anode 8, that is, the sum of the number of electrons absorbed by dynode 7 and the number of electrons absorbed by anode 8 is always assumed to be equal to twice the gain of dynode 5 (broken line) according to the measurement principle, and it is expected to remain substantially constant regardless of the potential of dynode 7. However, in a case where the potential of the dynode 7 is +2,350 V or more, the gain of the dynode 7 is a negative value meaning that electrons are absorbed, whereas in a case where the potential of the dynode 7 is within a range of +2,100 V to +2300 V, which is lower than +2,350 V, the gain of the dynode 7 is a positive value meaning that electrons are emitted, and the gain of the anode 8 is larger than the broken line which is the output defined by the measurement principle. Therefore, it can be seen that the anode 8 absorbs more electrons than the sum of the electrons output from the dynode 5 (twice the gain of the dynode 5), and the increment thereof generally corresponds to the positive gain value of the dynode 7. On the other hand, it has been also clarified that in a case where the potential of the dynode 7 becomes a value lower than the potential +2,112 V of the dynode 5, the electron emission capability decreases. Therefore, it can be seen that the dynode 7 multiplies electrons within a range where the potential of the dynode 7 is +2,112 V to +2,300 V, and accordingly, the gain of the anode 8 is also improved.

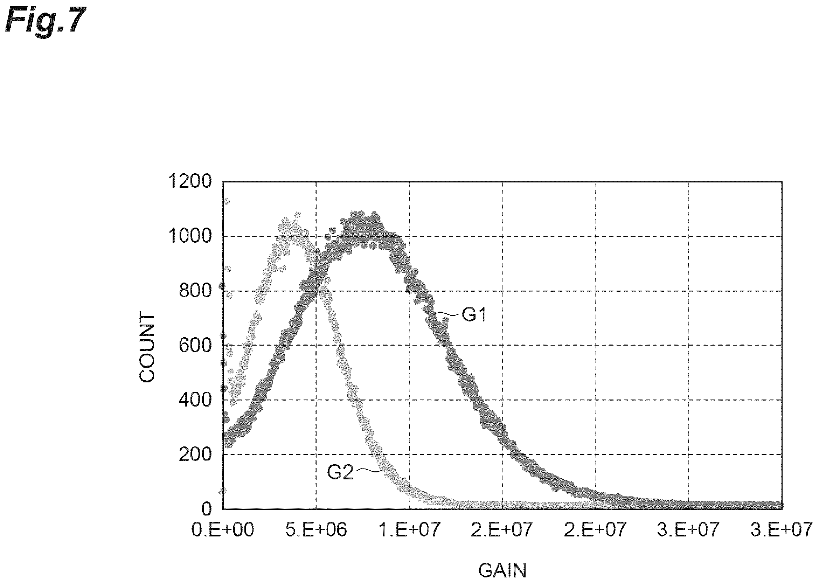

FIG. 7 is a graph illustrating the measurement result of the PHD characteristic in the MCP detector 1. In the graph illustrated in FIG. 7, the horizontal axis represents the gain, and the vertical axis represents the detection count number. The gain is the number of electrons included in one count of a pulse signal, and is defined as the peak position of the pulse-height distribution in the measurement result. Graphs G1 and G2 indicate output measurement results of the dynode 7 and the anode 8 in a case where the potential of the dynode 7 is set to +2,400 V, which is the same potential as that of the anode 8, and the potential of the dynode 5 is set to +2,112 V in the present embodiment. In addition, Graphs G1 and G2 indicate output measurement results of the dynode 7 and the anode 8 in a case where the potential of the dynode 7 is set to the same potential as that of the anode 8, +2,400 V, and the potential of the dynode 5 is set to +2,112 V in the present embodiment. It can be seen from these measurement results that the gain of the anode 8 is further improved by setting the potential of the dynode 7 to be lower than the potential of the anode 8.

Although various embodiments of the present invention have been described above, the present invention is not limited to the above-described embodiments, and may be modified or applied to other matters without changing the gist described in each claim.

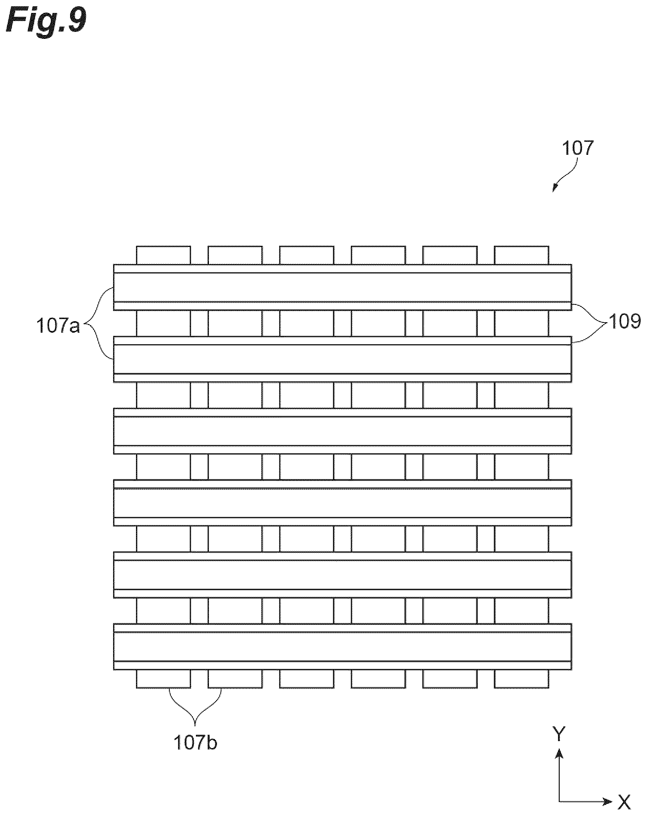

FIG. 9 is a plan view illustrating a configuration of a modification of the anode. An anode 107 illustrated in FIG. 9 includes linear anodes 107a constituting metal patterns formed on a plurality of insulators 109 extending in parallel with each other at a predetermined interval along the first direction X, and linear anodes 107b constituting a plurality of metal patterns extending in parallel with each other at a predetermined interval along the second direction Y. A plurality of linear anodes 107a and a plurality of linear anodes 107b are insulated from each other with the insulators 109 interposed therebetween. However, the plurality of linear anodes 107a and the plurality of linear anodes 107b may be spatially separated to be insulated from each other. The plurality of linear anodes 107a and the plurality of linear anodes 107b are electrically independently connected to the control unit 9. In the present modification, the signal processing unit 9a of the control unit 9 detects a pulse signal for each of the plurality of linear anodes 107a and the plurality of linear anodes 107b, and measures the distribution of the charge amount for each of lines of the plurality of linear anodes 107a and lines of the plurality of linear anodes 107b on the basis of each of pulse signals, thereby calculating an input position of an electron to the MCP.

In addition, in a case where the anode 8 has the configuration in which the wire anode 8a as illustrated in part (a) or part (b) of FIG. 2 is provided in two layers, and has the configuration illustrated in part (d) of FIG. 2, the signal processing unit 9a of the MCP detector 1 may have a function of generating a two-dimensional histogram as follows.

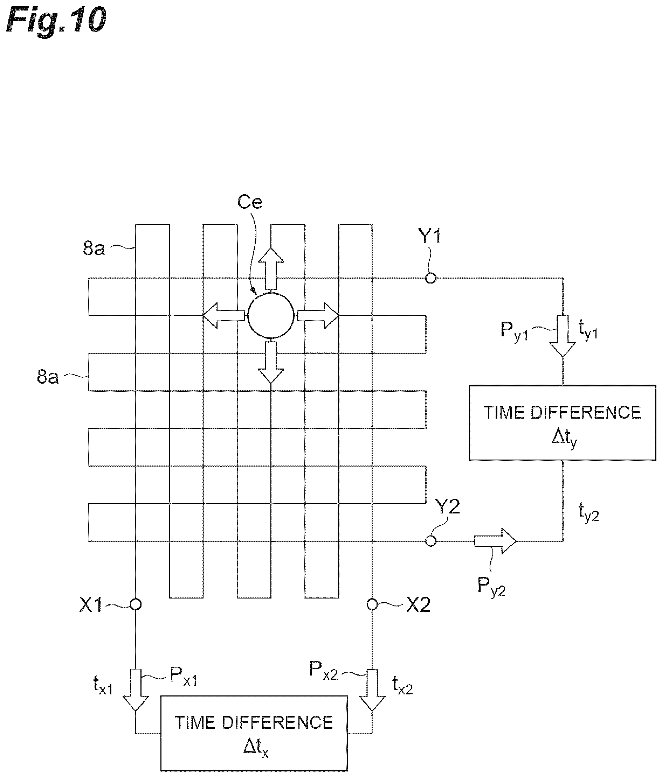

FIG. 10 is a diagram for explaining a method of calculating an input position by the signal processing unit 9a on the basis of pulse signals output from two layers of the wire anodes 8a. In a case where an output electron cloud Ce from the MCP 3 is captured by two layers of the wire anodes 8a, a pulse signal $P_{x1}$ corresponding to the captured amount in one wire anode 8a is propagated from a position of the output electron cloud Ce to a one end X1 of the wire anode 8a, and at the same time, a pulse signal $P_{x2}$ corresponding to the captured amount is propagated from the position of the output electron cloud Ce to the other end X2 of the wire anode 8a. Concurrently, a pulse signal $P_{y1}$ corresponding to the captured amount in the other wire anode 8a is propagated from the position of the output electron cloud Ce to one end Y1 of the wire anode 8a, and at the same time, a pulse signal $P_{y2}$ corresponding to the captured amount is propagated from the position of the output electron cloud Ce to the other end Y2 of the wire anode 8a.

The signal processing unit 9a detects the pulse signals $P_{x1}$, $P_{x2}$, $P_{y1}$, and $P_{y2}$ at a predetermined counting rate, and calculates two-dimensional coordinates (x,y) indicating the input position of the output electron cloud Ce using the propagation time difference by the following Equations (1) and (2) on the basis of detection timings $t_{x1}$, $t_{x2}$, $t_{y1}$, and $t_{y2}$ of the pulse signals. Here, $C_x$ and $C_y$ are predetermined constants.

$$x = C_x \cdot (t_{x1} - t_{x2}) \qquad ...(1)$$

$$y = C_y \cdot (t_{y1} - t_{y2}) \qquad ...(2)$$

The counting rate of the calculation of the two-dimensional coordinates in the signal processing unit 9a is set in advance to such a value that the next output electron cloud is not captured during the detection of one output electron cloud Ce according to the characteristics of the MCP3.

In addition, the signal processing unit 9a calculates the two-dimensional histogram by counting the two-dimensional coordinates calculated by the above-described method during a predetermined time, and generates an image representing the calculated two-dimensional histogram. With this image, it is possible to grasp the two-dimensional position distribution of the electrons input to the MCP 3 within the predetermined time.

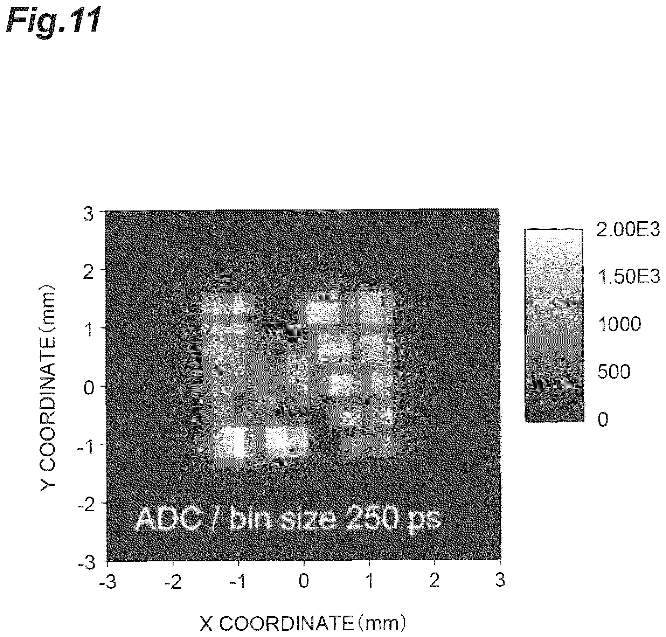

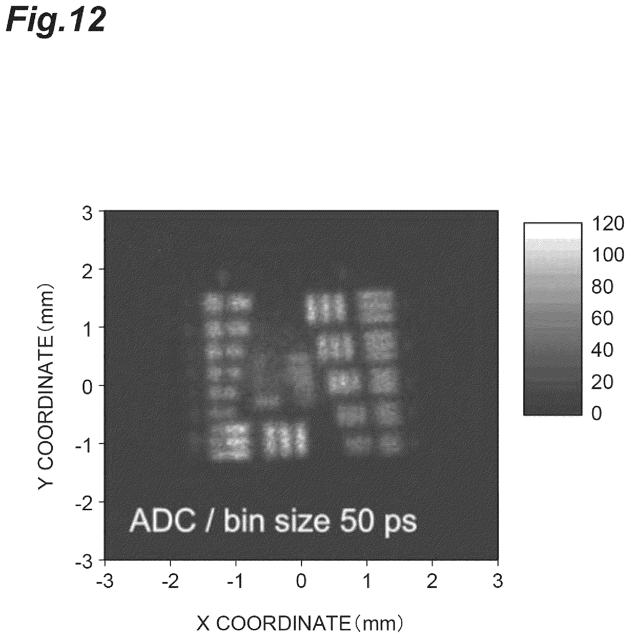

FIGS. 11 and 12 are diagrams, each illustrating a display example of an image generated by the signal processing unit 9a. FIG. 11 illustrates an image display example in a case where a two-dimensional histogram is generated with a bin size of 250 ps (picoseconds), and FIG. 12 illustrates an image display example in a case where a dimensional histogram is generated with a bin size of 50 ps. In this manner, the larger the bin size, the larger the count number, and the smaller the bin size, the higher the resolution of the image.

According to the MCP detector 1 of the modification described above, the counting rate can be improved while maintaining the MCP gain, and the number of wire anodes spanned by the input electron cloud can be maintained by maintaining the MCP gain. As a result, the resolution (positional accuracy or spatial resolution) in the image representing the two-dimensional coordinates of the electrons generated by the MCP detector 1 can be maintained.

In the present embodiment, the case where the charged particles to be detected by the MCP detector 1 are electrons is exemplified, but in a case where the MCP detector 1 is used as an ion detector, the charged particles input to the detector are ions. The input ions are converted into secondary electrons in the vicinity of the input surface of the MCP, and as a result, electrons are output from the output surface of the MCP.

In the above-described embodiments, it is suitable that a potential of the second dynode is higher than a potential of the output surface, and a potential of the anode is higher than a potential of the second dynode. With this setting, the electrons output from the output surface can efficiently reach the second dynode, and the electrons resulting from multiplication by the second dynode can be efficiently captured by the anode. As a result, the detection performance of the MCP detector or the analysis device including the MCP detector can be significantly improved.

In the above-described embodiments, it is also suitable that a potential of the second dynode is higher than a potential of the first dynode. In this case, the electrons resulting from multiplication by the first dynode can efficiently reach the second dynode. As a result, the detection performance of the MCP detector or the analysis device including the MCP detector can be further improved.

In addition, in the above-described embodiments, it is also suitable that the anode includes a thin metal wire extending in a direction along the plane, and the second dynode includes a thin metal wire extending in a direction along the plane. In this case, the output electrons of the MCP can be passed toward the first dynode with low loss, and the electrons resulting from multiplication by the first dynode and the second dynode can be acquired by the anode with low loss. As a result, the detection performance of the MCP detector or the analysis device including the MCP detector can be further significantly improved.

In addition, in the above-described embodiment, it is also suitable that the distance between the second dynode and the first dynode is set to be larger than the distance between the anode and the second dynode. In this case, the distance between the second dynode and the first dynode can be ensured, and the withstand voltage can be increased even in a case where the potential difference between the second dynode and the first dynode is set high in order to increase the gain in the first dynode.

In addition, in the above-described embodiments, it is also suitable that the anode is disposed closer to the first dynode than an intermediate position between an intermediate position between the output surface and the first dynode, and the first dynode. In this way, the incidence efficiency of the electrons output from the output surface of the MCP to the first dynode is improved, and the detection performance of the MCP detector can be further improved.

In addition, in the above-described embodiments, it is also suitable that the second dynode further includes a support member having insulating properties and supporting the second dynode, and the support member is provided outside, as viewed from the output surface, a region where a secondary electron-emitting film is provided on a surface of the first dynode. In a case where such a configuration is adopted, the collection efficiency of the electrons resulting from multiplication by the first dynode can be improved, and the detection performance of the MCP detector can be further improved.

In addition, in the above-described embodiment, it is also suitable that the anode further includes a support member having insulating properties and supporting the anode, and the support member is provided outside, as viewed from the output surface, a region where a secondary electron-emitting film is provided on the surface of the first dynode. In a case where such a configuration is adopted, the collection efficiency of the electrons resulting from multiplication by the first dynode can be improved, and the detection performance of the MCP detector can be further improved.

The MCP detector of the embodiment is [1] "An MCP detector including: a microchannel plate including an input surface to which a charged particle is input, a multiplier configured to multiply an electron generated in response to an input of the charged particle, and an output surface from which electrons resulting from multiplication by the multiplier are output; a first dynode disposed so as to be separated from the output surface and substantially parallel to the output surface, and configured to multiply the electrons output from the output surface, the first dynode being in a planar shape; an anode disposed between the output surface and the first dynode so as to be separated from the output surface and the first dynode, and configured to collect electrons resulting from multiplication by the first dynode; and a second dynode disposed between the anode and the first dynode so as to be separated from the anode and the first dynode, and configured to further multiply and allow the electrons resulting from multiplication by the first dynode to pass through the second dynode toward the anode".

The MCP detector of the embodiment may be [2] "the MCP detector according to [1], in which a potential of the second dynode is higher than a potential of the output surface, and a potential of the anode is higher than a potential of the second dynode".

The MCP detector of the embodiment may be [3] "the MCP detector according to [2], in which a potential of the second dynode is higher than a potential of the first dynode".

The MCP detector of the embodiment may be [4] "the MCP detector according to any one of [1] to [3], in which the anode includes a thin metal wire extending in a direction along the plane, and the second dynode includes a thin metal wire extending in a direction along the plane".

The MCP detector of the embodiment may be [5] "the MCP detector according to any one of [1] to [4], in which a distance between the second dynode and the first dynode is larger than a distance between the anode and the second dynode".

The MCP detector of the embodiment may be [6] "the MCP detector according to any one of [1] to [5], in which the anode is disposed closer to the first dynode than an intermediate position between an intermediate position between the output surface and the first dynode, and the first dynode".

The MCP detector of the embodiment may be [7] "the MCP detector according to any one of [1] to [6], in which the second dynode further includes a support member having insulating properties and configured to support the second dynode, and the support member is provided outside, as viewed from the output surface, a region where a secondary electron-emitting film is provided on a surface of the first dynode".

The MCP detector of the embodiment may be [8] "the MCP detector according to any one of [1] to [7], in which the anode further includes a support member having insulating properties and configured to support the anode, and the support member is provided outside, as viewed from the output surface, a region where a secondary electron-emitting film is provided on the surface of the first dynode".

The analysis device of the embodiment may be [9] "an analysis device including the MCP detector according to any one of [1] to [8]".

**Reference Signs List**

| 1 | MCP detector |
|---|---|
| 3 | MCP |
| 3a | Input surface |
| 3b | Output surface |
| 5 | Dynode (first dynode) |
| 7 | Dynode (second dynode) |
| 8, 107 | Anode |
| 8a, 107a, 107b | Wire anode, linear anode (thin metal wire) |
| 23 | Thin metal wire (metal wire) |
| 9 | Control unit |
| 9a | Signal processing unit |
| 11A, 11B | Multiplier |
| 13 | Thin metal wire (metal wire) |
| e1, e2, e3, e4 | Electron |
| X | First direction |
| Y | Second direction |

**Claims**

1. An MCP detector comprising:

   a microchannel plate including an input surface to which a charged particle is input, a multiplier configured to multiply an electron generated in response to an input of the charged particle, and an output surface from which electrons resulting from multiplication by the multiplier are output;
   a first dynode disposed so as to be separated from the output surface and substantially parallel to the output surface, and configured to multiply the electrons output from the output surface, the first dynode being in a planar shape;
   an anode disposed between the output surface and the first dynode so as to be separated from the output surface and the first dynode, and configured to collect electrons resulting from multiplication by the first dynode; and
   a second dynode disposed between the anode and the first dynode so as to be separated from the anode and the first dynode, and configured to further multiply and allow the electrons resulting from multiplication by the first dynode to pass through the second dynode toward the anode.

2. The MCP detector according to claim 1, wherein a potential of the second dynode is higher than a potential of the output surface, and a potential of the anode is higher than a potential of the second dynode.

**3.** The MCP detector according to claim 2, wherein a potential of the second dynode is higher than a potential of the first dynode.

**4.** The MCP detector according to any one of claims 1 to 3, wherein

the anode includes a thin metal wire extending in a direction along the plane, and the second dynode includes a thin metal wire extending in a direction along the plane.

**5.** The MCP detector according to any one of claims 1 to 4, wherein a distance between the second dynode and the first dynode is larger than a distance between the anode and the second dynode.

**6.** The MCP detector according to any one of claims 1 to 5, wherein the anode is disposed closer to the first dynode than an intermediate position between an intermediate position between the output surface and the first dynode, and the first dynode.

**7.** The MCP detector according to any one of claims 1 to 6, wherein

the second dynode further includes a support member having insulating properties and configured to support the second dynode, and the support member is provided outside, as viewed from the output surface, a region where a secondary electron-emitting film is provided on a surface of the first dynode.

**8.** The MCP detector according to any one of claims 1 to 7, wherein

the anode further includes a support member having insulating properties and configured to support the anode, and the support member is provided outside, as viewed from the output surface, a region where a secondary electron-emitting film is provided on the surface of the first dynode.

**9.** An analysis device comprising the MCP detector according to any one of claims 1 to 8.

Fig.1

Fig.2

EP 4 636 803 A1

*Fig.3*

## Fig.4

Fig.5

Fig.6

EP 4 636 803 A1

*Fig.7*

# Fig.8

EP 4 636 803 A1

# Fig.9

107

107a

109

107b

Y

X

# Fig.10

## Fig.11

Fig.12

## INTERNATIONAL SEARCH REPORT

International application No.

**PCT/JP2023/045776**

### A. CLASSIFICATION OF SUBJECT MATTER

***H01J 43/24***(2006.01)i; ***H01J 37/244***(2006.01)i; ***H01J 49/00***(2006.01)i; ***H01J 49/02***(2006.01)i
FI:  H01J43/24; H01J49/00 040; H01J37/244; H01J49/02 500

According to International Patent Classification (IPC) or to both national classification and IPC

### B. FIELDS SEARCHED

Minimum documentation searched (classification system followed by classification symbols)

H01J43/00; H01J37/244; H01J49/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2009-289693 A (HAMAMATSU PHOTONICS KK) 10 December 2009 (2009-12-10) fig. 2 | 1-9 |
| A | JP 2016-139606 A (HAMAMATSU PHOTONICS KK) 04 August 2016 (2016-08-04) fig. 2 | 1-9 |

☐ Further documents are listed in the continuation of Box C.    ☑ See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "D"  document cited by the applicant in the international application | "X"  document of particular relevance; the claimed invention cannot be considered novel or cannot be considered to involve an inventive step when the document is taken alone |
| "E"  earlier application or patent but published on or after the international filing date | |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| **09 February 2024** | **27 February 2024** |

| Name and mailing address of the ISA/JP | Authorized officer |
|---|---|
| **Japan Patent Office (ISA/JP)**
**3-4-3 Kasumigaseki, Chiyoda-ku, Tokyo 100-8915**
**Japan** | |
| | Telephone No. |

Form PCT/ISA/210 (second sheet) (July 2022)

## INTERNATIONAL SEARCH REPORT
### Information on patent family members

International application No.

**PCT/JP2023/045776**

| Patent document cited in search report | | | Publication date (day/month/year) | Patent family member(s) | | | Publication date (day/month/year) |
|---|---|---|---|---|---|---|---|
| JP | 2009-289693 | A | 10 December 2009 | US fig. 2 | 2011/0095174 | A1 | |
| JP | 2016-139606 | A | 04 August 2016 | US fig. 2 | 2016/0217995 | A1 | |
| | | | | CN | 105826159 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 57196466 A